# EUROPÄISCHE PATENTANMELDUNG

(11) **EP 1 357 602 A1**
(43) Veröffentlichungstag der Anmeldung: **29.10.2003**
(21) Anmeldenummer: 02006162.8
(22) Anmeldetag: 19.03.2002
(51) Int. Cl.: H01L 27/142, H01L 31/18

(54) **Selbstjustierende Serienverschaltung von Dünnschichten und Verfahren zur Herstellung**

(71) Anmelder: Scheuten Glasgroep, 5900 AA Venlo (NL)
(72) Erfinder: Geyer, Volker, 41372 Niederkrüchten (DE)
(74) Vertreter: Jostarndt, Hans-Dieter, Dr. Dipl.-Phys.

(57) **Zusammenfassung**

Die Erfindung betrifft eine selbstjustierende Serienverschaltung von Dünnschichten und ein Verfahren zur Herstellung.

Die Erfindung zeichnet sich dadurch aus, dass auf ein Substrat (10) elektrisch leitfähige Leiterbahnen (20) aufgebracht werden, woraufhin mehrere Hauptdepositionsschichten (30, 40, 50) aus leitfähigen, halbleitenden oder isolierenden Materialien auf das Substrat aufgebracht werden, wobei das Aufbringen der Schichten unter unterschiedlichen Einfallswinkeln zur Oberfläche des Substrats erfolgt.

## Beschreibung

Die Erfindung betrifft eine selbstjustierende Serienverschaltung von Dünnschichten und ein Verfahren zur Herstellung.

In der Industrie besteht ein zunehmender Bedarf nach Verfahren zur Herstellung von Serienverschaltungen von Dünnschichten, doch insbesondere in der Dünnschichtphotovoltaik ist das Problem der Serienverschaltung von Dünnschichtzellen noch nicht zufriedenstellend gelöst.

Die bekannteste Methode zum Herstellen von Serienverschaltungen von Dünnschichten ist das Aufbringen der einzelnen Schichten, unterbrochen von Prozessschritten, bei denen die aufgebrachte Schicht durch Laser oder mechanische Mittel getrennt wird. Typischerweise sind hierfür mehrere Bearbeitungsschritte erforderlich, bei denen die jeweils aufgebrachte Schicht durch Trennschnitte mit Unterbrechungen versehen wird.

Derartige Herstellungsverfahren weisen verschiedene Nachteile auf. Da die Schnitte, um tote Flächen zu minimieren, sehr nah beieinander liegen müssen, sich aber nicht überlappen oder kreuzen dürfen, da dies sonst zu Kurzschlüssen oder Fehlern führt, ist beispielsweise eine extrem genaue Ausrichtung des Substrats erforderlich. Ferner muss zur Realisierung eines Inline-Prozesses für jeden durchzuführenden Schnitt eine entsprechende Station eingerichtet werden. Wird das Verfahren dagegen nicht in einem Inline-Prozess durchgeführt, muss das Substrat für jeden Schnitt zu einer Schnittstation transportiert werden.

Aus der Internationalen Patentanmeldung WO 96/30935 ist ein Verfahren zur Herstellung von mehrschichtigen elektronischen Bauteilen bekannt, bei dem abwechselnd elektrisch leitfähige und isolierende Schichten aufgebracht werden. Dabei wird ein Substrat verwendet, auf dessen Oberfläche sich Stege mit rechteckigem Querschnitt befinden, so dass eine gerichtete Schichtdeposition unter einem Einfallswinkel eine Abschattung von Bereichen zwischen den Stegen bewirkt.

Aufgabe der Erfindung ist es, ein gattungsgemäßes Verfahren zur Herstellung von selbstjustierenden Serienverschaltungen von Dünnschichten so weiterzuentwickeln, dass es die Nachteile herkömmlicher Herstellungsverfahren vermeidet und wenige und einfach durchzuführende Verfahrensschritte aufweist.

Ferner ist es Aufgabe der Erfindung, eine selbstjustierende Serienverschaltung von Dünnschichten bereitzustellen, die durch wenige und einfach durchzuführende Verfahrensschritte hergestellt werden kann.

Erfindungsgemäß wird diese Aufgabe dadurch gelöst, dass elektrisch leitfähige Leiterbahnen auf ein Substrat aufgebracht werden und das Substrat mehreren Schichtdepositionen aus leitfähigen, halbleitenden und/oder isolierenden Materialien ausgesetzt wird, die unter verschiedenen Einfallswinkeln erfolgen.

Unter den verschiedenen Winkeln werden unterschiedliche Bereiche zwischen den Leiterbahnen abgeschattet und sind so der jeweiligen Materialdeposition nicht ausgesetzt, so dass sich ein Schichtaufbau ergibt, der serienverschaltete Dünnschichten ausbildet, durch die ein Stromfluss stattfinden kann.

Die aufgebrachten Leiterbahnen haben vorzugsweise einen rechteckigen Querschnitt, es sind aber auch andere Querschnittsgeometrien möglich. Beispielsweise können die Leiterbahnen einen dreieckigen, trapezförmigen oder runden Querschnitt aufweisen. Die Leiterbahnen werden auf eine Substratfläche aufgebracht. Nach Aufbringung der Leiterbahnen wird das Substrat nacheinander verschiedenen Schichtdepositionen ausgesetzt, wobei die einzelnen Depositionen unter verschiedenen Einfallswinkeln erfolgen. Die Richtung der jeweiligen Deposition steht vorzugsweise senkrecht zur Längsausrichtung der Leiterbahnen und in einem Winkel zur Oberfläche des Substrats, so dass zwischen den Leiterbahnen Bereiche entstehen, die von den Leiterbahnflanken abgeschattet werden und somit keiner Deposition ausgesetzt sind.

In einer besonders bevorzugten Ausführungsform der Erfindung werden für eine Serienverschaltung von Dünnschichten drei Hauptdepositionsschichten aus verschiedenen Materialien und unter verschiedenen Winkeln aufgebracht. Diese Hauptschichten können wiederum aus mehreren Einzelschichten bestehen, die vorzugsweise unter dem gemeinsamen Winkel der Hauptschicht aufgebracht werden. Mit dem erfindungsgemäßen Verfahren können jedoch auch Serienverschaltungen mit mehr als drei Hauptschichten hergestellt werden, oder die Hauptschichten werden durch weitere Schichten und/oder Bearbeitungsvorgänge ergänzt.

Im Folgenden wird ein besonders bevorzugtes Ausführungsbeispiels einer Serienverschaltung, bestehend aus drei Hauptschichten, beschrieben. Bei der ersten Hauptdepositionsschicht handelt es sich vorzugsweise um einen Rückkontakt aus einem leitenden oder halbleitenden Material. Diese erste Deposition unter einem ersten Einfallswinkel α bewirkt eine Beschichtung des Substrats, einer Flanke und der Oberseite einer Leiterbahn, wobei ein bestimmter Bereich hinter den Leiterbahnen nicht mit dem leitenden oder halbleitenden Material beschichtet wird. In einem bestimmten Abstand hinter den Leiterbahnen erfolgt wieder eine Beschichtung des Substrats, die sich an der Flanke der nächsten Leiterbahn fortsetzt. Die Wahl des Einfallswinkels der Deposition richtet sich demnach nach dem erforderlichen nicht zu beschichtenden Bereich hinter den Leiterbahnen.

Bei der zweiten Hauptschicht handelt es sich vorzugsweise um einen Halbleiter. Es hat sich als zweckmäßig erwiesen, dass diese zweite Schichtdeposition unter einem Winkel β von 90° zur Substratoberfläche erfolgt, so dass nun die Oberseiten der Leiterbahnen und die Bereiche zwischen den Leiterbahnen vollständig beschichtet werden. Erfolgt die zweite Deposition unter einem von 90° verschiedenen Winkel zur Substratoberfläche, werden auch Flankenseiten der Leiterbahnen beschichtet. Dies ist für eine Serienverschaltung der Schichten zu vermeiden, da die Schicht des später aufzubringenden Vorderkontakts keine Berührung zum Rückkontakt haben darf, und eine Verbindung über die Beschichtung der Flanken zu einem Kurzschluss führen würde. Erfolgt dennoch eine Beschichtung der Flanken, müssen diese vor Aufbringung des Vorderkontakts gereinigt werden.

Eine dritte Deposition erfolgt wiederum unter einem dem ersten Winkel α entgegengesetzten Einfallswinkel γ, und bei dieser Schicht handelt es sich vorzugsweise um einen elektrisch transparenten Vorderkontakt aus einem leitenden oder halbleitenden Material.

Die verschiedenen Schichten können auch aus mehreren Einzelschichten bestehen, die zweckmäßigerweise jeweils unter einem der Hauptschicht gemeinsamen Winkel aufgebracht werden. Vor allem die zweite Halbleiterschicht kann in Verbindung mit weiteren Prozessschritten durch Einzelschichten gebildet werden.

Durch die beschriebene Wiederholung von Schichtdepositionen unter verschiedenen Winkeln bildet sich eine Serienverschaltung von Dünnschichten aus, die sich insbesondere zur Verwendung für Solarzellen eignet.

Es hat sich als besonders zweckmäßig erwiesen, die Schichtdepositionen mittels eines PVD-Verfahrens durchzuführen und die Schichtpartikel aufzusputtern. Es können aber auch andere Beschichtungsverfahren wie das Sprühen oder CVD-Verfahren verwendet werden.

Das beschriebene Verfahren zur Herstellung von selbstjustierenden Serienverschaltungen von Dünnschichten zeichnet sich durch diverse Vorteile gegenüber herkömmlichen Verfahren aus. Zum einen ist keine absolut präzise Ausrichtung des zu beschichtenden Substrats erforderlich, da der Abschattungsbereich die Trennbereiche bestimmt. Zum anderen kann durch geeignete Aufbringmittel die Schattenbreite und somit der nichtaktive Bereich auf ein Minimum reduziert werden. Ferner ist das Verfahren gut in einem Inline-Prozess durchführbar, da das Substrat nicht zwischen einzelnen Bearbeitungsstationen hin- und her transportiert werden muss, sondern an einer einzigen Station mit geeigneten Aufbringmitteln bearbeitet werden kann. Ein Kreuzen der Trennbereiche ist ebenfalls nicht möglich, so dass Fehlerquellen und Kurzschlüsse ausgeschlossen werden.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: ein Ausführungsbeispiel eines Substrats mit aufgebrachten Leiterbahnen;
- Fig. 2: das Aufbringen einer ersten Schicht unter einem Einfallswinkel α;
- Fig. 3: das Aufbringen einer zweiten Schicht unter einem Einfallswinkel β;
- Fig. 4: das Aufbringen einer dritten Schicht unter einem Einfallswinkel γ und
- Fig. 5: den Stromverlauf in der sich ergebenden Serienverschaltung der Dünnschichten.

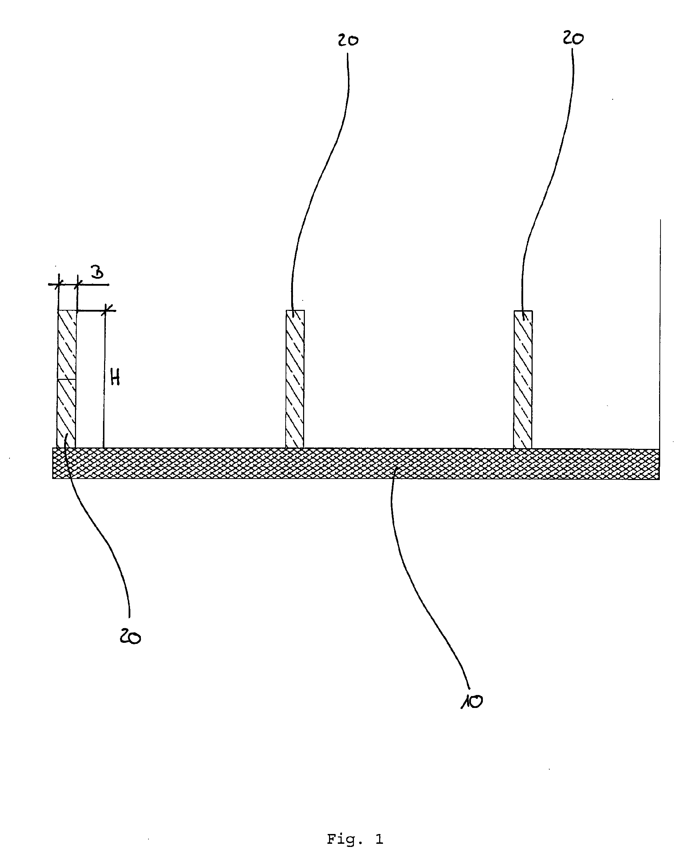

In Fig. 1 ist ein Substrat 10 dargestellt, auf das mehrere im Wesentlichen parallel zueinander verlaufende Leiterbahnen 20 aufgebracht wurden. Dabei umfasst der Ausdruck "im Wesentlichen" exakt parallel verlaufende Leiterbahnen und Leiterbahnen, die um bis zu 50% des Abstands zwischen den Leiterbahnen von der Parallelität abweichen. Bei dem Substrat kann es sich beispielsweise um Glas, insbesondere um Floatglas handeln.

Ein weiteres geeignetes Substrat stellt Polymerfolie dar. Die Leiterbahnen 20 sind elektrisch leitfähig und können aus leitfähigen Polymermassen, leitfähigen Glasfritten, metallischen Bändern oder sonstigen Materialien bestehen. Der Querschnitt der Leiterbahnen ist vorzugsweise rechteckig, es können aber auch andere Querschnitte gewählt werden. Beispielsweise können die Leiterbahnen einen dreieckigen, trapezförmigen oder runden Querschnitt aufweisen. Die dreieckigen Leiterbahnen können so aufgebracht werden, dass eine Seitenfläche mit der Substratoberfläche verbunden ist. Trapezförmige Leiterbahnen werden zweckmäßigerweise so aufgebracht, dass sich der Querschnitt zur Substratoberfläche hin verjüngt.

Die Leiterbahnen können beispielsweise mittels Siebdruck aufgebracht werden, wobei die Breite B der Bahnen durch das Sieb und die Eigenschaften der verwendeten Paste bestimmt wird, während die Höhe H vorrangig durch die Anzahl der Druckvorgänge bestimmt wird. Für den Siebdruck kann beispielsweise Graphit- und/oder Silberpaste verwendet werden. Die resultierenden Abmessungen der Leiterbahnen liegen zweckmäßigerweise in folgenden Größenordnungen: Breite B = 10 µm - 500 µm und Höhe H = 5 µm - 500 µm. Die Länge der Leiterbahnen ist beliebig wählbar und hängt vorrangig von den Abmessungen des zu beschichtenden Substrats ab. Typische Anwendungen verwenden Leiterbahnen mit Längen L in der Größenordnung von 30 cm bis 6 m. Die Anzahl der aufgebrachten Leiterbahnen ist daher ebenfalls beliebig wählbar, wobei sie vorzugsweise im Bereich von 50 bis 200 /m liegt. Der Abstand zwischen den einzelnen Leiterbahnen 20 ergibt sich entsprechend der gewählten Abmessungen.

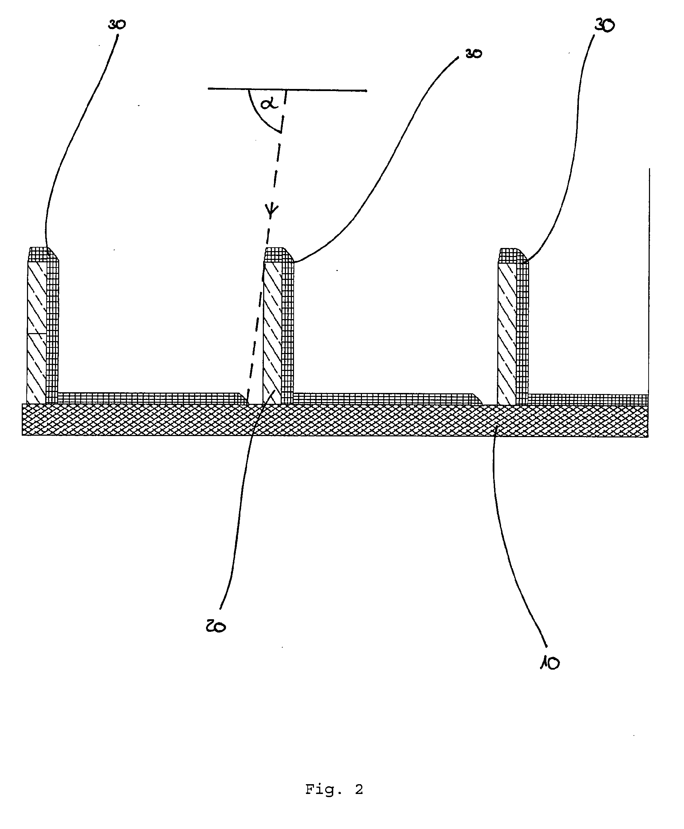

In Fig. 2 ist ein Ausführungsbeispiel dargestellt, bei dem nach dem erfindungsgemäßen Verfahren eine erste Hauptschicht 30 auf das Substrat 10 und die Leiterbahnen 20 aufgebracht wird. Diese erste Schichtdeposition erfolgt unter einem ersten Einfallswinkel α in Bezug auf die Oberfläche des Substrats und zweckmäßigerweise senkrecht zur Längsausrichtung der Leiterbahnen 20. Der Winkel zwischen der Längsausrichtung der Leiterbahnen und der Richtung der Deposition kann jedoch auch von 90° abweichen. Dabei sind Winkel zwischen 90° und 1° möglich.

Der Abbildung in Fig. 2 ist zu entnehmen, dass durch die Beschichtung unter einem Winkel zur Substratoberfläche hinter den Leiterbahnen abgeschattete Bereiche entstehen, die somit keiner Deposition ausgesetzt sind. Es erfolgt daher eine Beschichtung der Oberseiten und der Flanken der Leiterbahnen, die der Deposition ausgesetzt sind, und der Bereiche zwischen den Leiterbahnen, die nicht im Schatten der Leiterbahnen liegen. Die Dicke der so aufgebrachten ersten Dünnschicht liegt typischerweise in der Größenordnung von 50 nm bis 50 µm.

Bei dieser ersten Schicht handelt es sich in einer besonders bevorzugten Ausführungsform um einen Rückkontakt, dessen Hauptbestandteil Molybdän ist. Für die Rückkontaktschicht können jedoch auch andere Materialien wie leitfähige Kleber, Silber oder TCOs (Transparent Conductive Oxides) wie ZnO:Al oder Indium-dotiertes Zinnoxid (ITO) verwendet werden.

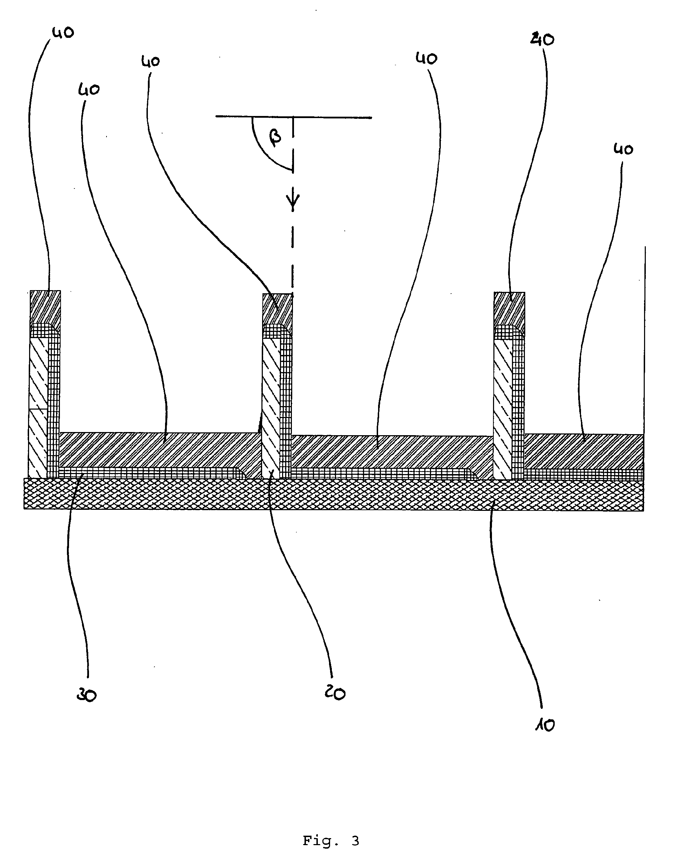

Der Abbildung in Fig. 3 ist zu entnehmen, wie eine zweite Hauptschicht 40 auf das Substrat 10 und die Leiterbahnen 20 aufgebracht wird. Diese Schichtdeposition erfolgt vorzugsweise unter einem zweiten Einfallswinkel β von 90° zur Substratoberfläche, so dass nun die Oberseiten und die Bereiche zwischen den Leiterbahnen vollständig beschichtet werden.

Als zweite Schicht wird ein Dünnschichthalbleiter aufgebracht. Für einen Cu-In-Ga-Selenid-Halbleiter wird beispielsweise eine Schichtfolge aus Kupfer, Indium, Gallium und Selen aufgebracht, während für einen Si-Halbleiter amorphes Silizium aufgebracht wird. Zur Bildung der Halbleiterschicht können jedoch auch andere Materialien verwendet werden.

Die Einzelschichten zur Bildung der Schichtfolge der gesamten Halbleiterschicht werden vorzugsweise alle in einem gemeinsamen Winkel von 90° zur Substratoberfläche aufgebracht, wobei die Schichtdepositionen abwechselnd von verschiedenen anderen Prozessschritten unterbrochen sein können. Die resultierende Schichtdicke ist abhängig vom eingesetzten Halbleiter und dessen Absorptionskoeffizienten für solare Strahlung. Typische Halbleiterschichtdicken der Dünnschichtvoltaik liegen in der Größenordnung von 200 nm bis 5 µm.

Erfolgt die zweite Beschichtung unter einem von 90° verschiedenen Winkel zur Substratoberfläche, werden auch die Flanken der Leiterbahnen beschichtet. Dies ist für eine Serienverschaltung der Dünnschichten zu vermeiden, da die Schicht des später aufzubringenden Vorderkontakts keine Berührung zum Rückkontakt der ersten Schicht haben darf, und eine Verbindung über die Beschichtung der Flanken zu einem Kurzschluss führen würde. Erfolgt dennoch eine Beschichtung der Flanken, müssen diese vor Aufbringung des folgenden Vorderkontakts gereinigt werden. Die Reinigung kann zwischen der Aufbringung der Einzelschichten und der weiteren Prozessschritte oder nach Abschluss der zweiten Schicht erfolgen. Zur Reinigung können beispielsweise Ätzverfahren und/oder mechanische Verfahren verwendet werden.

Nach Aufbringung des Dünnschichthalbleiters sind weitere Verfahrensschritte zur Ausbildung eines p/h-Übergangs erforderlich. Dazu wird in einer besonders bevorzugten Ausführungsform der Erfindung eine Cadmium-Sulfid-Schicht aufgebracht. Die Aufbringung kann beispielsweise durch das Verfahren der Chemical Bath Deposition erfolgen. Diese Schicht ist in den Abbildungen der Figuren 1 bis 5 nicht dargestellt.

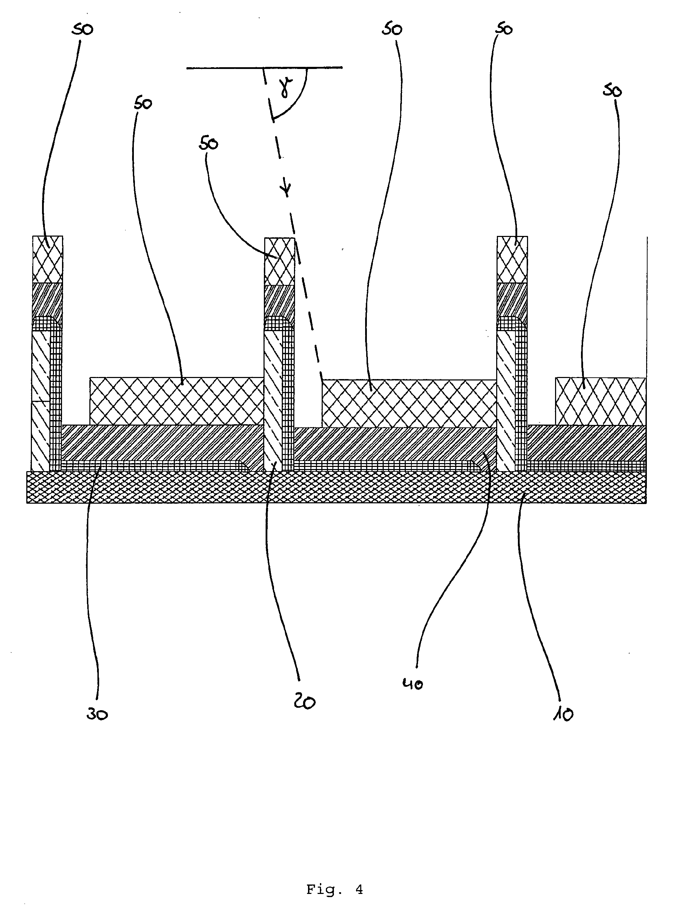

Der Abbildung in Fig. 4 ist der darauf folgende Verfahrensschritt des Aufbringens einer dritten Hauptschicht 50 unter einem Einfallswinkel γ zu entnehmen. Dabei erfolgt die Beschichtung vorzugsweise entgegen dem ersten Beschichtungswinkel α. Bei dieser dritten Schicht kann es sich beispielsweise um einen elektrisch transparenten Vorderkontakt aus Materialien wie Indium-dotiertem Zinnoxid (ITO), ZnO:Al, Gold oder Silber handeln.

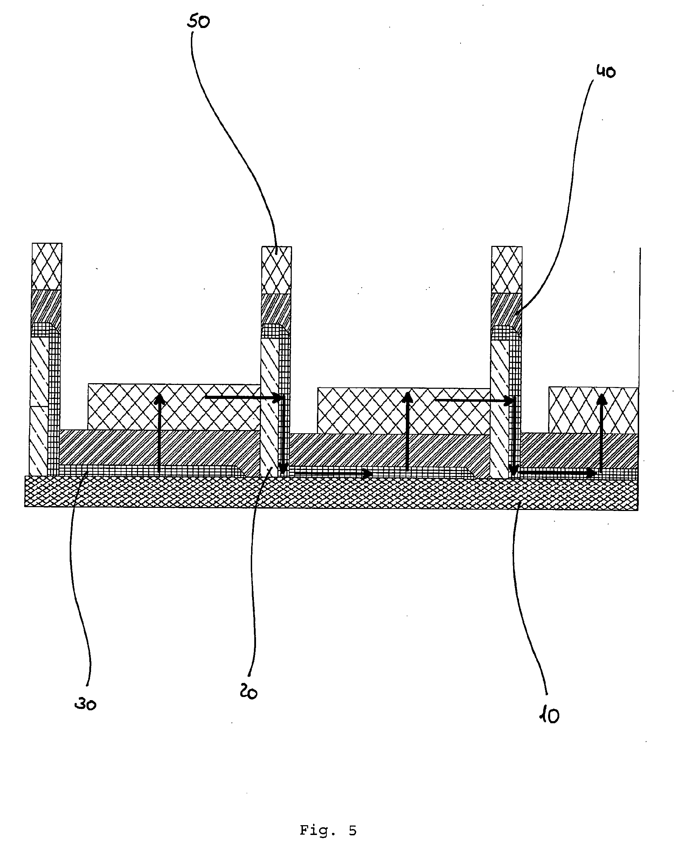

Durch das erfindungsgemäße Aufbringen der diversen Schichten ist eine Serienverschaltung von Dünnschichten entstanden, wie sie in Fig. 5 dargestellt ist. In der Abbildung ist der resultierende Stromverlauf mit einem Pfeilverlauf dargestellt. Der Strom wird durch das Substrat 10 in den Rückkontakt 30 und über die Schicht 40 in den Vorderkontakt 50 geleitet. Von dort fließt er durch eine Leiterbahn 20 erneut in den Rückkontakt und von dort wieder über den Vorderkontakt in die nächste Leiterbahn.

### Bezugszeichenliste:

- 10: Substrat
- 20: Elektrisch leitfähige Leiterbahnen
- 30: Erste Depositionsschicht unter einem ersten Einfallswinkel α
- 40: Zweite Depositionsschicht unter einem zweiten Einfallswinkel β
- 50: Dritte Depositionsschicht unter einem dritten Einfallswinkel γ

## Patentansprüche

1. Verfahren zur Herstellung von selbstjustierenden Serienverschaltungen von Dünnschichten, **gekennzeichnet durch** folgende Verfahrensschritte:
- Aufbringen elektrisch leitfähiger Leiterbahnen (20) auf ein Substrat (10),
- Aufbringen mehrerer Depositionsschichten aus leitenden, halbleitenden und/oder isolierenden Materialien auf das Substrat (10), wobei
- das Aufbringen der Depositionsschichten unter verschiedenen Einfallswinkeln in Bezug zur Oberfläche des Substrats (10) erfolgt.

2. Verfahren nach Anspruch 1, **dadurch gekennzeichnet, dass** die elektrisch leitfähigen Leiterbahnen (20) im Wesentlichen parallel zueinander verlaufen.

3. Verfahren nach einem oder beiden der Ansprüche 1 und 2, **dadurch gekennzeichnet, dass** die elektrisch leitfähigen Leiterbahnen (20) mittels Siebdruck aufgebracht werden.

4. Verfahren nach Anspruch 3, **dadurch gekennzeichnet, dass** zur Aufbringung der elektrisch leitfähigen Leiterbahnen (20) mittels Siebdruck Graphitund/oder Silberpaste verwendet wird.

5. Verfahren nach einem oder beiden der Ansprüche 1 und 2, **dadurch gekennzeichnet, dass** die elektrisch leitfähigen Leiterbahnen (20) mit einem leitfähigen Kleber auf das Substrat aufgeklebt werden.

6. Verfahren nach einem oder mehreren der vorangegangenen Ansprüche, **dadurch gekennzeichnet, dass** das gerichtete Aufbringen der Depositionsschichten unter einem Winkel mittels eines PVD-Verfahrens erfolgt.

7. Verfahren nach einem oder mehreren der vorangegangenen Ansprüche, **dadurch gekennzeichnet, dass** die Flussrichtung der aufgebrachten Materialteilchen zur Bildung der Depositionsschichten senkrecht zur Ausrichtung der Leiterbahnen (20) verläuft.

8. Verfahren nach einem oder mehreren der vorangegangenen Ansprüche, **dadurch gekennzeichnet, dass** nach Aufbringen der Leiterbahnen (20) auf das Substrat (10) wenigstens eine erste Hauptschichtdeposition (30) unter einem ersten Einfallswinkel α zur Oberfläche des Substrats (10) erfolgt, eine zweite Hauptschichtdeposition (40) unter einem zweiten Einfallswinkel β und eine dritte Hauptschichtdeposition (50) unter einem dritten Einfallswinkel γ erfolgt, wobei der Winkel β 90° beträgt und der Winkel γ dem Winkel α entgegengesetzt ist.

9. Verfahren nach einem oder mehreren der vorangegangenen Ansprüche, **dadurch gekennzeichnet, dass** nach Aufbringen der Leiterbahnen (20) auf das Substrat (10) wenigstens eine erste Hauptschichtdeposition (30) unter einem ersten Einfallswinkel α zur Oberfläche des Substrats (10) erfolgt, eine zweite Hauptschichtdeposition (40) unter einem zweiten Einfallswinkel β und eine dritte Hauptschichtdeposition (50) unter einem dritten Einfallswinkel γ erfolgt, wobei der Winkel β verschieden zu 90° ist und der Winkel γ dem Winkel α entgegengesetzt ist.

10. Verfahren nach einem oder mehreren der vorangegangenen Ansprüche, **dadurch gekennzeichnet, dass** wenigstens eine der Hauptschichten (30, 40, 50) aus verschiedenen Einzelschichten gebildet wird, wobei die Aufbringung der Einzelschichten unter einem der jeweiligen Schicht gemeinsamen Winkel erfolgt.

11. Verfahren nach einem oder mehreren der vorangegangenen Ansprüche, **dadurch gekennzeichnet, dass** die Aufbringung der Hauptschichten (30, 40, 50) und/oder deren Einzelschichten von weiteren Prozessschritten unterbrochen wird.

12. Verfahren nach einem oder mehreren der Ansprüche 9 bis 11, **dadurch gekennzeichnet, dass** nach Aufbringung der zweiten Hauptschicht (40) oder Einzelschichten der Hauptschicht (40) unter einem Winkel β verschieden von 90° eine Reinigung der Flanken der Leiterbahnen (20) erfolgt.

13. Verfahren nach Anspruch 12, **dadurch gekennzeichnet, dass** die Reinigung der Flanken durch Ätzverfahren erfolgt.

14. Verfahren nach Anspruch 12, **dadurch gekennzeichnet, dass** die Reinigung der Flanken mechanisch erfolgt.

15. Selbstjustierende Serienverschaltung von Dünnschichten, **dadurch gekennzeichnet, dass** sie mit dem durch die Ansprüche 1 bis 14 beschriebenen Verfahren hergestellt wurde.

16. Serienverschaltung von Dünnschichten nach Anspruch 15, **dadurch gekennzeichnet, dass** das Substrat (10) aus Glas besteht.

17. Serienverschaltung von Dünnschichten nach Anspruch 16, **dadurch gekennzeichnet, dass** das Substrat (10) aus Floatglas besteht.

18. Serienverschaltung von Dünnschichten nach Anspruch 15, **dadurch gekennzeichnet, dass** das Substrat (10) aus Polymerfolie besteht.

19. Serienverschaltung nach einem oder mehreren der Ansprüche 15 bis 18, **dadurch gekennzeichnet, dass** die Abmessungen der elektrisch leitfähigen Leiterbahnen (20) in der Größenordnung Länge L = 30 cm bis 6 m, Höhe H = 5 µm bis 500 µm und Breite B = 10 µm bis 500 µm liegen.

20. Serienverschaltung nach einem oder mehreren der Ansprüche 15 bis 19, **dadurch gekennzeichnet, dass** sich auf der Oberfläche des Substrats (10) 50 bis 200 Leiterbahnen /m befinden.

21. Serienverschaltung nach einem oder mehreren der Ansprüche 15 bis 20, **dadurch gekennzeichnet, dass** die Leiterbahnen (20) aus leitfähigen Polymermassen oder leitfähigen Glasfritten bestehen.

22. Serienverschaltung nach einem oder mehreren der Ansprüche 15 bis 21, **dadurch gekennzeichnet, dass** die erste Hauptdepositionsschicht (30) einen Rückkontakt bildet.

23. Serienverschaltung nach Anspruch 22, **dadurch gekennzeichnet, dass** der Hauptbestandteil der ersten Depositionsschicht (30) aus der Gruppe Molybdän, leitfähige Kleber, Silber oder TCOs wie ZnO:Al und/oder Indium-dotiertes Zinnoxid (ITO) ist.

24. Serienverschaltung nach einem oder mehreren der Ansprüche 15 bis 23, **dadurch gekennzeichnet, dass** die zweite Hauptdepositionsschicht (40) einen Dünnschichthalbleiter bildet.

25. Serienverschaltung nach Anspruch 24, **dadurch gekennzeichnet, dass** die zweite Depositionsschicht (40) durch eine Schichtfolge aus Kupfer, Indium, Gallium und Selen gebildet wird.

26. Serienverschaltung nach Anspruch 24, **dadurch gekennzeichnet, dass** der Hauptbestandteil der zweiten Depositionsschicht (40) amorphes Silizium ist.

27. Serienverschaltung nach einem oder mehreren der Ansprüche 15 bis 26, **dadurch gekennzeichnet, dass** die dritte Hauptdepositionsschicht (50) einen elektrisch transparenten Vorderkontakt bildet.

28. Serienverschaltung nach Anspruch 27, **dadurch gekennzeichnet, dass** der Hauptbestandteil der dritten Depositionsschicht (50) Indium-dotiertes Zinnoxid, ZnO:Al, Gold und/oder Silber ist.
